Europäisches Patentamt

European Patent Office

Office européen des brevets

(19)

(11) Veröffentlichungsnummer: **0 334 900 B1**

# (12) EUROPÄISCHE PATENTSCHRIFT

(45) Veröffentlichungstag der Patentschrift:
25.09.91 Patentblatt 91/39

(51) Int. Cl.⁵: **B23B 51/00, B23B 31/08**

(21) Anmeldenummer: 88901542.6

(22) Anmeldetag: 06.02.88

(86) Internationale Anmeldenummer:
PCT/DE88/00058

(87) Internationale Veröffentlichungsnummer:
WO 88/06070 25.08.88 Gazette 88/19

(54) **HINTERSCHNITTBOHRER.**

(30) Priorität: 13.02.87 DE 3704491

(43) Veröffentlichungstag der Anmeldung:
04.10.89 Patentblatt 89/40

(45) Bekanntmachung des Hinweises auf die
Patenterteilung:
25.09.91 Patentblatt 91/39

(84) Benannte Vertragsstaaten:
AT BE CH DE FR GB IT LI LU NL SE

(56) Entgegenhaltungen:
DE-A- 3 022 464
DE-A- 3 143 462
GB-A- 579 528
US-A- 2 392 039

(73) Patentinhaber: Upat GmbH & Co
Freiburger Strasse 9 Postfach 1320
W-7830 Emmendingen (DE)

(72) Erfinder: RINKLAKE, Manfred
Studentenweg 23
W-6382 Friedrichsdorf (DE)
Erfinder: STEURER, Paul
Belchenstrasse 9
W-7830 Teningen (DE)
Erfinder: FRISCHMANN, Albert
Hürnheimweg 3
W-7832 Kenzingen (DE)

(74) Vertreter: Rackette, Karl, Dipl.-Phys. Dr.-Ing
Kaiser-Joseph-Strasse 179 Postfach 1310
W-7800 Freiburg (DE)

## Beschreibung

Die Erfindung betrifft einen Hinterschnittbohrer mit einem Einspannzapfen, einer auf dem Bohrlochrand abstützbaren Auslenkplatte, an der ein Bohrschaft mit einem Schneidteil gegenüber dem Lot auf die Anschlagfläche der Auslenkplatte geneigt befestigt ist, wobei der Einspannzapfen mit dem Bohrschaft über ein Gelenk verbunden ist.

Ein derartiger Hinterschnittbohrer zum Erzeugen von Hinterschneidungen in vorgebohrten Leichtbauwerkstoffen ist aus der DE-A-3022464 bekannt und dient zur Vorbereitung einer Verankerung von Befestigungselementen durch Formschluß im hinterschnittenen Teil der Bohrung. Bei der bekannten Vorrichtung ist der das Schneidteil aufweisende Bohrschaft gegenüber der Längsachse des Einspannzapfens und damit dem Lot auf die Anschlagfläche der Auslenkplatte leicht beweglich befestigt und mit Hilfe einer Feder um einen fest vorgegebenen maximalen Auslenkwinkel vorgespannt. Erst nach dem Erstellen einer zylindrischen Vorbohrung wird der das Schneidteil aufweisende Bohrschaft in diese eingeführt und die Bohrmaschine oder der Bohrhammer in Betrieb gesetzt. Dabei rührt das durch die Feder gegen die Bohrlochwandung angedrückte Schneidteil im zylindrischen Bohrloch herum, wobei nur bei Leichtbauwerkstoffen ein ausreichendes Abtragen der zylindrischen Seitenwände erfolgt und die Schlagenergie eines Bohrhammers wegen des Nachgebens der Feder nicht übertragbar ist.

Bei einem anderen aus der DE-A-3022464 bekannten Hinterschnittbohrer ohne Gelenk mit einem starr befestigten Schneidteil wird durch ein Verschwenken der Längsachse der Bohrmaschine oder des Bohrhammers bezüglich der Längsachse der zylindrischen Vorbohrung erreicht, daß die konische Hinterschneidung nach und nach erstellt wird. Dabei werden auf die Welle des Bohrhammers und der Bohrmaschine sowie die entsprechenden Lager des Bohrgerätes seitliche Kräfte ausgeübt, die üblicherweise bei Bohrgeräten nicht vorkommen.

In der DE-A-3027408 ist eine Bohrvorrichtung zur Herstellung von Bohrlöchern mit Hinterschneidung beschrieben, bei der der Bohrschaft fluchtend zur Längsachse des Bohrgerätes fest eingespannt ist und zusammen mit dem Bohrgerät in einem Kugelgelenk geführt ist, das ein Verschwenken des Bohrschaftes in einem zylindrisch vorgebohrten Bohrloch gestattet. Auch bei dieser Vorrichtung werden die Lager des Bohrgerätes stark strapaziert. Bei einem längeren Hebelarm besteht außerdem die Gefahr, daß sich die Bohrerwelle verbiegt. Schließlich ist zum Verschwenken des Bohrgerätes ein Bewegungsfreiraum erforderlich, der nicht immer zur Verfügung steht, so daß mit der bekannten Vorrichtung beispielsweise in der Nähe von Ecken und Kanten keine Bohrlöcher mit einer Hinterschneidung erstellt werden können.

In der DE-A-3143462 wird vorgeschlagen, einen Bohrschaft eines Bohrwerkzeuges zum Herstellen von Hinterschneidungen in vorgebohrten Bohrlöchern an seinem vorderen Ende mit parallel überstehenden Schneidplatten zu versehen.

Der Erfindung liegt die Aufgabe zugrunde, einen Hinterschnittbohrer der eingangs genannten Art zu schaffen, der es gestattet, sowohl in Leichtbaustoffen als auch in Beton in einem Arbeitsgang ohne kreisförmiges Verschwenken der Bohrmaschine oder des Bohrhammers ein konisch hinterschnittenes Bohrloch zu erstellen.

Diese Aufgabe wird erfindungsgemäß dadurch gelöst, daß der Bohrschaft an seinem vorderen Ende als Schneidteil über eine radial überstehende Schneidplatte verfügt und an der Auslenkplatte unbeweglich befestigt ist, die ihrerseits an dem Einspannzapfen mit Hilfe eines drehmomentübertragenden Gelenkes mit zwei Bewegungsfreiheiten beweglich befestigt ist, das in einem fest mit der Rückseite der Auslenkplatte verbundenen Gehäuse untergebracht ist, das auf der von der Auslenkplatte wegweisenden Seite eine Öffnung aufweist, durch die in alle Richtungen verschwenkbar ein Mitnahmeteil herausragt, das mit dem Einspannzapfen verbunden ist.

Durch das Gelenk werden sowohl Drehkräfte als auch axiale Schlagkräfte eines Bohrhammers auf die Schneidplatte übertragen, wobei ein Verschwenken der Bohrmaschine oder des Bohrhammers nicht mehr erforderlich ist, weil die Anschlagfläche der Auslenkplatte bei der Berührung mit dem Bohrlochrand ein Kippmoment auf den Bohrschaft überträgt, das sich wegen des Gelenkes nicht auf den Einspannzapfen überträgt, weil es eine Ubertragung sowohl axialer Kräfte als auch von Drehmomenten vom Einspannzapfen zum Bohrschaft gestattet, wobei zwischen dem Einspannzapfen und dem Bohrschaft veränderliche Winkel eingenommen werden können.

Das Gelenk ist in einem Gehäuse vorgesehen, das auf seiner zum Bohrschaft weisenden Seite mit einer kreisscheibenförmigen Auslenkplatte abgedeckt ist, die bei einem zweckmäßigen Ausführungsbeispiels der Erfindung keilförmig in einer Richtung verjüngt ist. Durch eine solche Ausbildung wird erreicht, daß die Längsachsen des Bohrschaftes und des Einspannzapfens während der Erstellung des zylindrischen Teils des Bohrloches miteinander fluchten.

Um ein Beschädigen der Oberfläche um den Bohrlochrand zu vermeiden, kann die Anschlagfläche der Auslenkplatte mit einer Kunststoffplatte überzogen sein.

Weitere zweckmäßige Ausgestaltungen sind in den Unteransprüchen gekennzeichnet.

Die Erfindung wird nachfolgend anhand von in der Zeichnung dargestellten Ausführungsbeispielen näher beschrieben. Es zeigen :

Fig. 1 einen Hinterschnittbohrer gemäß der Erfindung beim Erstellen eines konisch hinterschnittenen Bohrloches während dreier Phasen des Arbeitsvorganges in einer Seitenansicht mit aufgeschnittener Bohrlochwand,

Fig. 2 eine der Fig. 1 entsprechende Darstellung mit einem Hinterschnittbohrer, dessen Auslenkplatte eine gleichförmige Stärke aufweist,

Fig. 3 einen Hinterschnittbohrer, der in Fig. 2 gezeigten Art im Halbschnitt,

Fig. 4 die am vorderen Ende des Bohrschaftes eingesetzte Schneidplatte in einer Stirnansicht und

Fig. 5 die Schneidplatte in einer Seitenansicht.

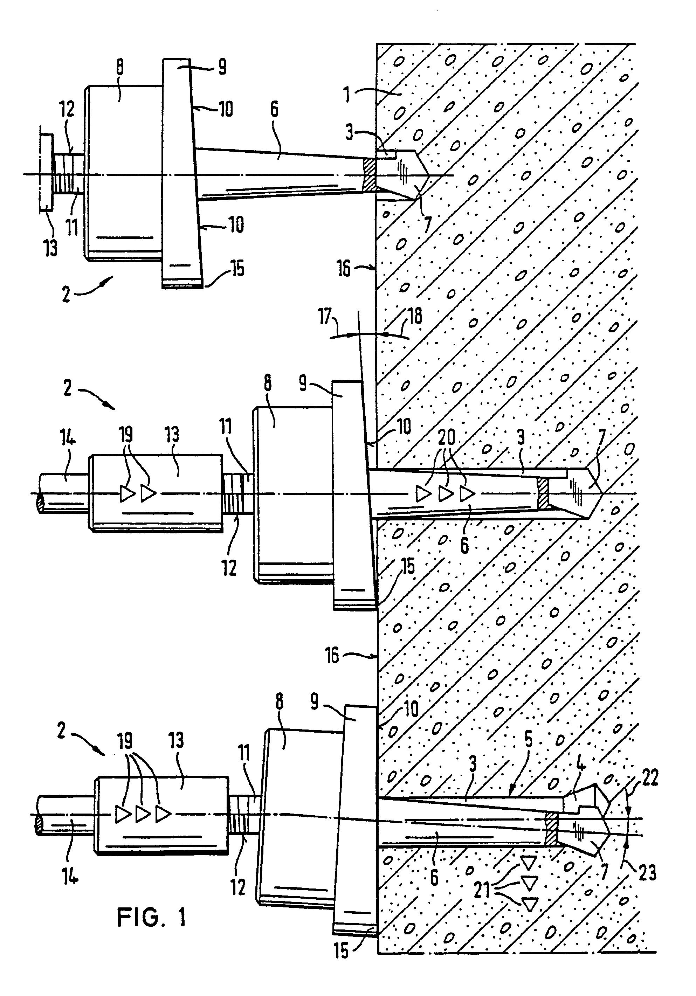

In Fig. 1 erkennt man auf der rechten Seite eine Wand 1, die aus Beton, einem Leichtbaustoff oder einem Mauerwerk besteht. Mit dem links gezeichneten Hinterschnittbohrer 2 wird in die Wand 1 zunächst eine zylindrische Vorbohrung 3 erstellt, wie man in Fig. 1 oben und in der Mitte erkennen kann. In Fig. 1 unten ist der Hinterschnittbohrer 2 zusammen mit dem im Anschluß an die zylindrische Vorbohrung 3 erstellten Hinterschnitt 4 dargestellt. Wenn die in Fig. 1 unten dargestellte Form der Vorbohrung 3 mit dem Hinterschnitt 4 erreicht ist, wird der Hinterschnittbohrer 2 aus dem hinterschnittenen Bohrloch 5 herausgezogen, um ein Befestigungselement einzusetzen, das mit seinem vorderen Ende im Hinterschnitt 4 einen Formschluß bewirkt.

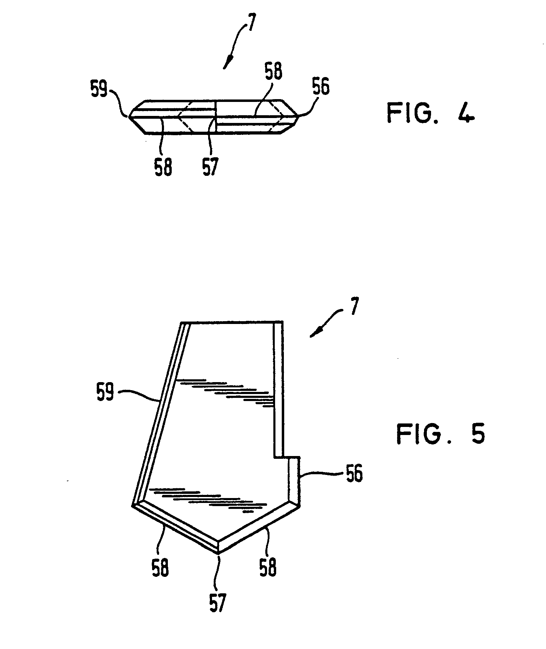

Der Hinterschnittbohrer 2 verfügt über einen Bohrschaft 6, der an seinem vorderen Ende mit einer Schneidplatte 7 versehen ist, deren Gestalt weiter unten anhand der Figuren 4 und 5 näher beschrieben ist. Die Schneidplatte 7 dient einerseits zur Erstellung der zylindrischen Vorbohrung 3 und andererseits zur Erstellung der konischen Hinterschneidung 4. Vorzugsweise besteht die Schneidplatte 7 aus einem Hartmetall.

Zur Bohrmehlabfuhr ist der Bohrschaft 6 mit ihn schraubenlinienförmig umwindenden Nuten versehen, die in der Zeichnung nicht dargestellt sind. Der Bohrschaft 6 ist starr mit einem Gehäuse 8 verbunden, das an der zur Schneidplatte 7 weisenden Seite eine Auslenkplatte 9 aufweist, die über eine schräg zur Längsachse des Bohrschaftes 6 verlaufende Anschlagfläche 10 verfügt. Das Gehäuse 8 sowie die mit der schrägen Anschlagfläche 10 versehene Auslenkplatte 9 haben einen kreisförmigen Querschnitt. Der Durchmesser der Auslenkplatte 9 kann zur Anpassung an die Schlagwirkung des jeweils verwendeten Bohrhammers und das Material der Wand 1 verschieden sein und z.B. für kleinere Bohrhämmer größer gewählt sein.

Auf der dem Bohrschaft 6 gegenüberliegenden Seite ragt aus dem Gehäuse 8 eine Mitnahmeschraube 11 heraus, über die dem Bohrschaft 6 mit der radial überstehenden Schneidplatte 7 eine schlagend drehende Bewegung verliehen werden kann. Die Mitnahmeschraube 11 verfügt über ein Außengewinde 12, das in eine Gewindeaufnahme 13 eingeschraubt ist. Die Gewindeaufnahme 13 ist ihrerseits mit einem Einspannzapfen 14 versehen, der zur Befestigung des Hinterschnittbohrers 2 in der Werkzeugaufnahme eines Bohrhammers oder einer Schlagbohrmaschine, die in der Zeichnung nicht dargestellt sind, dient.

Wenn der Bohrhammer in Betrieb gesetzt wird, ist es in der in Fig. 1 oben gezeigten Weise möglich, die Vorbohrung 3 zu erzeugen, wobei die Längsachsen der Gewindeaufnahme 13 und der Mitnahmeschraube 11 mit den Längsachsen des Gehäuses 8 und des Bohrschaftes 6 fluchten. Auf diese Weise werden Schläge des Bohrhammers und Druckkräfte zusammen mit Rotationskräften auf die Schneidplatte 7 übertragen, die in die Wand 1 eindringt und dabei die Vorbohrung 3 erzeugt, bis die in Fig. 1 in der Mitte dargestellte Lage der Anschlagfläche 10 der Auslenkplatte 9 erreicht wird. Wie man in Fig. 1 in der Mitte erkennt, gelangt die schräg zur Längsachse des Bohrschaftes 6 verlaufende Anschlagfläche 10 zunächst mit einem in der Nähe des äußeren Umfangs liegenden Randbereich 15 mit der Oberfläche 16 der Wand 1 in Berührung. Infolge der Abschrägung der Auslenkplatte 9 um den durch die Pfeile 17 und 18 veranschaulichten Keilwinkel wird bei der Berührung des Randbereichs 15 der Oberfläche 16 ein Kippmoment auf die Auslenkplatte 9 und den damit starr verbundenen Bohrschaft 6 erzeugt.

Wie bereits oben erwähnt, ist die Mitnahmeschraube 11 drehfest mit dem Gehäuse 8 verbunden. Die Verbindung ist dabei jedoch als Kardangelenk ausgebildet, so daß eine Kraftübertragung von dem mit der Mitnahmeschraube 11 starr verbundenen Einspannzapfen 14 zum Bohrschaft 6 möglich ist, wobei der angetriebene Bohrschaft 6 zum antreibenden Einspannzapfen 14 einen veränderlichen Winkel einnehmen kann.

Aufgrund des im Gehäuse 8 vorgesehenen Kardangelenks werden die in Richtung der Pfeile 19 eingeleiteten axial schlagenen Bohrkräfte, die bis zur Berührung des Randbereiches 15 mit der Oberfläche 16 ausschließlich in Richtung der Pfeile 20 übertragen werden, in die in Fig. 1 unten durch die Pfeile 21 dargestellte Richtung radial umgelenkt, so daß ausgehend von der in Fig. 1 in der Mitte dargestellten Form der zylindrischen Vorbohrung 3 das in Fig. 1 unten dargestellte hinterschnittene Bohrloch 5 erstellt wird, indem auf die Schneidplatte 7 in Richtung der Pfeile 21 Schlag- und Druckkräfte ausgeübt werden, während sich die Auslenkplatte 9 dreht und mit einem immer größer werdenden Bereich der Anschlagfläche 10 mit der Oberfläche 16 in Berührung kommt, bis der in Fig. 1 unten dargestellte Endzustand erreicht ist, bei dem zwischen der Längsachse des Einspannzapfens 14 und der Längsachse des Bohrschaftes 6 ein durch die Pfeile 22, 23 veranschaulichter Kippwinkel besteht, der dem Keilwinkel der Anschlagfläche 10 der Auslenkplatte 9 entspricht.

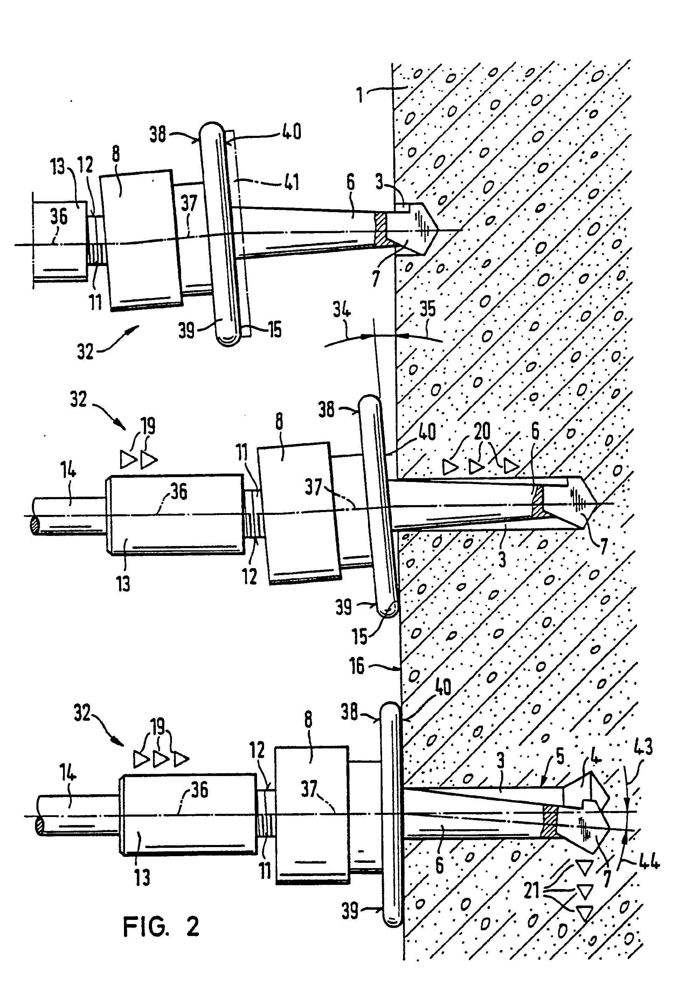

In Fig. 2 ist ein Hinterschnittbohrer 32 dargestellt, dessen Wirkungsweise im wesentlichen der Wirkungsweise des Hinterschnittbohrers 2 gemäß Fig. 1 entspricht. In Fig. 2 sind entsprechend Fig. 1 die verschiedenen Phasen des Vorgangs zur Erstellung eines hinterschnittenen Bohrloches 5 dargestellt. Entsprechende Teile tragen in Fig. 2 die im Zusammenhang mit der Beschreibung der Fig. 1 erörterten Bezugszeichen.

Im Gegensatz zum Hinterschnittbohrer 2 verfügt der Hinterschnittbohrer 32 über eine Auslenkplatte 39, deren Rückseite 38 parallel zur Anschlagfläche 40 verläuft. Wie bei dem Hinterschnittbohrer 2 ist die Längsachse des Bohrschaftes 6 gegenüber dem Lot auf die Anschlagfläche 40 geneigt. Im Gegensatz zum Hinterschnittbohrer 2 fluchten die Längsachsen des Gehäuses 8 und des Bohrschaftes 6 nicht miteinander, was in Fig. 2 oben zu erkennen ist, wo die Längsachse des Gehäuses 8 mit dem Bezugszeichen 37 versehen ist und die seitlich gegenüber der Längsachse des Bohrschaftes 6 versetzte Längsachse des Einspannzapfens 14 mit dem Bezugszeichen 36 versehen ist.

In Fig. 2 erkennt man entsprechend Fig. 1 einen durch Pfeile 34, 35 veranschaulichten Keilwinkel zwischen der Ebene der Anschlagfläche 40 und der rechtwinklig zur Bohrlochlängsachse verlaufenden Ebene der Oberfläche 16 der Wand 1.

Nach dem Erreichen der in der Mitte von Fig. 2 dargestellten Bohrlochtiefe beginnt das Verkippen der Auslenkplatte 39 und damit das radiale Ausschwenken der Schneidplatte 7 an der Spitze des Bohrschaftes 6, wobei der Winkel zwischen der Längsachse des Einspannzapfens 14 und der Längsachse des Gehäuses 8 stetig verändert wird bis beide Achsen miteinander fluchten und die Längsachse des Bohrschaftes 6 mit den miteinander fluchtenden Achsen den in Fig. 2 unten durch die Pfeile 43, 44 veranschaulichten Winkel einschließen.

In Fig. 2 oben ist strichpunktiert eine zusätzliche Platte 41 aus Kunststoff dargestellt, die auf der Anschlagfläche 40 oder 10 vorgesehen sein kann, um die Oberfläche 16 der Wand 1 vor einer Beschädigung zu schützen, wenn diese aus einem Leichtbaustoff besteht.

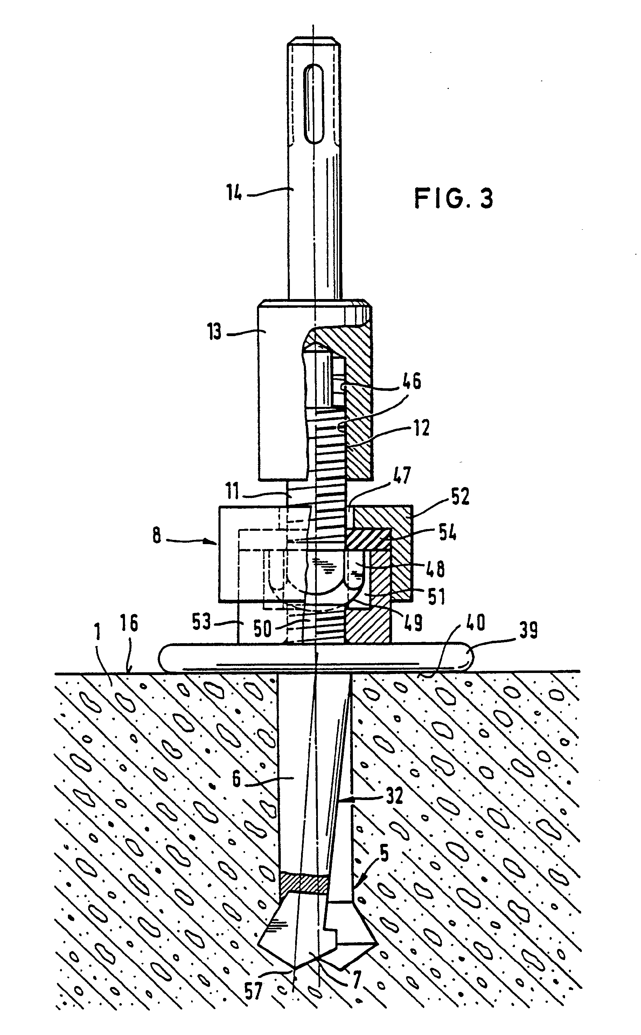

In Fig. 3 ist der Aufbau des Hinterschnittbohrers 32 im Teilschnitt in einer Position dargestellt, die derjenigen in Fig. 2 unten entspricht. Gleiche Teile sind wiederum mit gleichen Bezugszeichen versehen.

In Fig. 3 erkennt man den Einspannzapfen 14 zum Einspannen des Hinterschnittbohrers 32 in einen Bohrhammer oder eine Schlagbohrmaschine. Die mit dem Einspannzapfen 14 starr verbundene Gewindeaufnahme 13 verfügt über ein Innengewinde 46, in das das Außengewinde 12 der Mitnahmeschraube 11 eingreift. Die Mitnahmeschraube 11 ragt durch eine Öffnung 47 aus den Gehäuse 8 heraus. Wie man in Fig. 3 erkennt, läßt die Öffnung 47 zwischen dem Außengewinde 12 und dem Gehäuse 8 einen Ringspalt frei, so daß die Mitnahmeschraube 11 ungehindert in allen Richtungen verkippt werden kann.

Die Mitnahmeschraube 11 verfügt über einen Sechskantkopf 48, der auf seiner Stirnseite 49 konvex ausgebildet ist, um unabhängig vom Kippwinkel eine Druckkraft auf das in das Gehäuse 8 hineinragende Ende 50 des Bohrschaftes (6) ausüben zu können, in dem eine konkave Vertiefung entsprechend der konvexen Erhöhung am Sechskantkopf 48 vorgesehen sein kann.

Der Sechskantkopf 48 befindet sich in einer entsprechend geformten sechskantigen Ausnehmung 51 im Gehäuse 8, das in der in Fig. 3 erkennbaren Weise aus einen Oberteil 52 und einem Unterteil 53 besteht. Zwischen dem Oberteil 52 und dem Unterteil 53 ist ein elastisches Rückstellelement 54 vorgesehen, gegen das der Sechskantkopf 58 angedrückt ist.

Wie man in Fig. 3 erkennt, ist die Auslenkplatte 39 rechtwinklig zur Längsachse des Gehäuses 8 an dessen Unterteil 53 befestigt. Der Bohrschaft 6 ist gegenüber der Mittelsenkrechten auf die Auslenkplatte 39 seitlich gekippt, um bei einem Aufliegen der Auslenkplatte 39 auf die Oberfläche 16 ein Kippmoment und infolgedessen eine Hinterschneidung 4 zu erzeugen.

In den Figuren 4 und 5 ist die Schneidplatte 7 vergrößert dargestellt. Die Schneidplatte 7 verfügt über eine sich parallel zur Längsachse des Bohrschaftes 6 erstreckende Führungsschneide 56, mit deren Hilfe die zylindrische Vorbohrung 3 erstellt wird. Nach vorne in Richtung der Bohrerspitze 57 erstrecken sich beidseitig symmetrische Schneiden 58. Weiterhin verfügt die Schneidplatte 7 über eine zur Längsachse des Bohrschaftes 6 schräg verlaufende Seitenschneide 59, was in Fig. 5 in einer Seitenansicht und in Fig. 4 in einer Stirnansicht dargestellt ist.

## Patentansprüche

1. Hinterschnittbohrer mit einem Einspannzapfen (14), einer auf dem Bohrlochrand (16) abstützbaren Auslenkplatte (9), an der ein Bohrschaft (6) mit einem Schneidteil (7) gegenüber dem Lot auf die Anschlagfläche (10) der Auslenkplatte (9, 39) geneigt befestigt ist, wobei der Einspannzapfen (14) mit dem Bohrschaft (6) über ein Gelenk (8) verbunden ist, **dadurch gekennzeichnet, daß** der Bohrschaft (6) an seinem vorderen Ende als Schneidteil über eine radial überstehende Schneidplatte (7) verfügt und an der Auslenkplatte (9, 39) unbeweglich befestigt ist, die ihrerseits an dem Einspannzapfen (14) mit Hilfe eines drehmomentübertragenden Gelenkes (8) mit zwei Bewegungsfreiheiten beweglich befestigt ist, das in einem fest mit der Rückseite (38) der Auslenkplatte (9, 39) verbundenen Gehäuse (8) untergebracht ist, das auf der von der Auslenkplatte (9, 39) wegweisenden Seite eine Öffnung (47) aufweist, durch die in alle Richtungen verschwenkbar ein Mitnahmeteil (11) herausragt, das mit dem Einspannzapfen (14) verbunden ist.

2. Hinterschnittbohrer nach Anspruch 1, **dadurch gekennzeichnet, daß** das Mitnahmeteil eine Mitnahmeschraube (11) ist, die einen Sechskantkopf (48) mit balliger Stirnseite (49) aufweist, der in einer sechskantigen Ausnehmung (51) im Gehäuse (8) verkippbar geführt ist und mit seiner balligen Stirnseite (49) auf dem in der Auslenkplatte (9, 39) befestigten hinteren Ende des Bohrschaftes (6) abgestützt ist.

3. Hinterschnittbohrer nach Anspruch 2, **dadurch gekennzeichnet, daß** dem Sechskantkopf (48) ein Rückstellelement (54) zugeordnet ist.

4. Hinterschnittbohrer nach einem der vorstehenden Ansprüche, **dadurch gekennzeichnet, daß** die Auslenkplatte (9) eine einseitig keilförmig verjüngte kreisförmige Scheibe ist.

5. Hinterschnittbohrer nach Anspruch 1, **dadurch gekennzeichnet, daß** die Auslenkplatte eine kreisförmige Scheibe (9, 39) ist, deren Anschlagfläche (10, 40) mit einer Kunststoffplatte (41) überzogen ist.

6. Hinterschnittbohrer nach einem der Ansprüche 1 bis 5, **dadurch gekennzeichnet, daß** die Schneidplatte (7) eine parallel zur Längsachse des Bohrschaftes (6) verlaufende, beim Erstellen des zylindrischen Teils (3) des Bohrloches (5) wirksame Führungsschneide (56) aufweist.

7. Hinterschnittbohrer nach einem der Ansprüche 1 bis 6, **dadurch gekennzeichnet, daß** die Schneidplatte (7) eine geneigt zur Längsachse des Bohrschaftes (6) verlaufende, beim Erstellen der konischen Hinterschneidung des Bohrloches (5) wirksame Seitenschneide (59) aufweist.

## Claims

1. An undercutting drill comprising a clamping spigot (14), a deflection plate (9) which can bear against the edge (16) of the drilled hole and to which a drill shank (6) with a cutting portion (7) is secured inclinedly relative to a line perpendicular to the abutment surface (10) of the deflection plate (9, 39), the clamping spigot (14) being connected to the drill shank (6) by way of a joint (8), characterised in that at its front end the drill shank (6) has a radially projecting cutting plate (7) as the cutting portion and is immovably secured to the deflection plate (9, 39) which in turn is movably secured to the clamping spigot (14) by means of a torque-transmitting joint (8) with two freedoms of movement, which is disposed in a housing (8) which is fixedly connected to the rear side (38) of the deflection plate (9, 39) and which on the side facing away from the deflection plate (9) has an opening (47) through which an entrainment portion (11) projects therefrom pivotably in all directions, the entrainment portion (11) being connected to the clamping spigot (14).

2. An undercutting drill according to claim 1 characterised in that the entrainment portion is an entrainment screw (11) having a hexagonal head (48) with a spherically curved end (49) which is tiltably guided in a hexagonal recess (51) in the housing (8) and which is supported with its spherically curved end (49) against the rear end of the drill shank (6), which is fastened in the deflection plate (9, 39).

3. An undercutting drill according to claim 2 characterised in that a return element (54) is associated with the hexagonal head (48).

4. An undercutting drill according to one of the preceding claims characterised in that the deflection plate (9) is a circular disc which reduces in a tapering configuration at one side.

5. An undercutting drill according to claim 1 characterised in that the deflection plate is a circular disc (9, 39), the abutment surface (10, 40) of which is covered with a plastics plate (41).

6. An undercutting drill according to one of claims 1 to 5 characterised in that the cutting plate (7) has a guide cutting edge (56) which extends parallel to the longitudinal axis of the drill shank (6) and which is operative when producing the cylindrical part (3) of the drilled hole (5).

7. An undercutting drill according to one of claims 1 to 6 characterised in that the cutting plate (7) has a side cutting edge (59) which extends inclinedly relative to the longitudinal axis of the drill shank (6) and which is operative when producing the conical undercut portion of the drilled bole (5).

## Revendications

1. Foret pour réaliser des perçages à dépouille comportant un nez de fixation (14), un plateau de sortie (9) pouvant prendre appui sur la périphérie (16) du perçage, sur lequel est fixée une queue (6) avec un partie coupante (7) inclinée par rapport à la perpendiculaire à la surface d'appui (10) du plateau de sortie (9, 39), le nez de fixation (14) étant relié à la queue (6) par une articulation (8), caractérisé en ce que la queue (6) est munie sur son extrémité distale conformée en partie coupante d'une plaque de coupe (7) en saillie radialement et qu'elle est montée fixe sur le plateau de sortie (9, 39), qui de son côté est relié au nez de fixation (14) au moyen d'une articulation (8) transmettant un mouvement de rotation, avec deux degrés de liberté, articulation qui est rapportée dans un logement (8) relié de manière fixe à la face arrière (38) du plateau de sortie (9, 39), logement qui présente sur sa face opposée un plateau de sortie (9, 39) une ouverture (47) au travers de laquelle une pièce d'entrainement (11) peut être inclinée dans toutes les directions, pièce d'entrainement reliée au nez de fixation (14).

2. Foret pour réaliser des perçages à dépouille selon la revendication 1, caractérisé en ce que la pièce d'entrainement consiste en une vis d'entrainement (11), qui présente une face frontale (49) en rotule avec une tête à six pans (48), qui est guidée dans un évidement (51) à six pans de manière à pouvoir être inclinée et qui vient en appui au moyen de sa face frontale (49) en rotule sur l'extrémité arrière de la queue (6) fixée au plateau de sortie (9, 39).

3. Foret pour réaliser des perçages à dépouille selon la revendication 2, caractérisé en ce que à la tête à six pans (48) est associé un élément de rappel (54).

4. Foret selon l'une quelconque des revendications précédentes, caractérisé en ce que le plateau de sortie (9) est un disque circulaire s'amincissant sur un côté en forme de coin.

5. Foret selon la revendication 1, caractérisé en ce que le plateau de sortie est un disque circulaire (9, 39), dont la surface d'appui (10, 40) est revêtue d'une plaque (41) en matériau synthétique.

6. Foret selon la revendication l'une des revendications 1 à 5, caractérisé en ce que la plaque de coupe (7) présente une lame de guidage (56) s'étendant parallèlement à l'axe longitudinal de la queue (6), agissant lors de la réalisation de la partie cylindrique (3) de l'orifice (5).

7. Foret selon l'une quelconque des revendications 1 à 6, caractérisé en ce que la plaque de coupe (7) présente une zone de coupe latérale (59) s'étendant de manière inclinée par rapport à l'axe longitudinal de la queue (6), lors de la réalisation de la dépouille conique de l'orifice (5).

FIG. 1

FIG. 2

FIG. 3

FIG. 4

FIG. 5